# FASCICULE DE BREVET EUROPEEN

(11) **EP 3 365 927 B1**
(45) Date de publication et mention de la délivrance du brevet: **24.03.2021**
(21) Numéro de dépôt: 16798236.2
(22) Date de dépôt: 17.10.2016
(51) Int. Cl.: H01L 41/08, H01L 41/312, H03H 9/02

(54) **STRUCTURE COMPOSITE ET PROCÉDÉ DE FABRICATION ASSOCIÉ**
VERBUNDSTRUKTUR UND ZUGEHÖRIGES HERSTELLUNGSVERFAHREN
COMPOSITE STRUCTURE AND ASSOCIATED PRODUCTION METHOD

(30) Priorité: 20.10.2015 FR 1559994
(43) Date de publication de la demande: 29.08.2018
(73) Titulaire: Soitec, 38190 Bernin (FR)
(72) Inventeur: GUENARD, Pascal, 38190 Froges (FR); RADU, Ionut, 38920 Crolles (FR); LANDRU, Didier, 38190 Le Champ-Pres-Froges (FR); DESBONNETS, Eric, 38660 Lumbin (FR)
(74) Mandataire: IP Trust
(86) Numéro de dépôt international: PCT/FR2016/052675
(87) Numéro de publication internationale: WO 2017/068270

(56) Documents cités:
- EP-A1- 2 104 228
- WO-A1-02/37556

## Description

### DOMAINE DE L'INVENTION

La présente invention concerne le domaine des structures composites et hétéro-structures. Elle concerne en particulier les structures composites pour dispositifs à ondes acoustiques.

### ARRIERE PLAN TECHNOLOGIQUE DE L'INVENTION

Dans le domaine des dispositifs à ondes acoustiques de surface ou de volume (respectivement « SAW » pour « Surface Acoustic Wave » et « BAW » pour « Bulk Acoustic Wave » selon la terminologie anglo-saxonne), les hétéro-structures comportant une couche de tantalate de lithium (LiTaO3) disposée sur un substrat de silicium, présentent un intérêt croissant : d'une part, parce qu'elles sont compatibles avec des équipements et procédés standard de la microélectronique grâce à leur substrat support en silicium, d'autre part parce qu'elles présentent des avantages techniques comme par exemple une moindre dépendance, vis-à-vis de la température, de la réponse en fréquence des dispositifs SAW comme expliqué dans l'article de K.Hashimoto, M.Kadota et al., « Recent development of temperature compensated SAW devices », IEEE Ultrason. Symp. 2011, pages 79 à 86, 2011. Un autre exemple d'un tel structure composite est divulgué en EP 2 104 228 A1, où une couche diélectrique sur la couche piézoélectrique sert de supprimer des réflexions parasites.

Les hétéro-structures LiTaO3/Si peuvent par exemple être élaborées à partir de l'assemblage par collage par adhésion moléculaire de deux substrats respectivement de LiTaO3 et de Si. Pour la fabrication de dispositifs à ondes acoustiques sur ces hétéro-structures, il est avantageux de pouvoir monter à une température au moins égale à 250°C, ceci pour permettre l'utilisation de matériaux et de procédés garantissant de bonnes performances des dispositifs. La tenue de l'interface de collage entre la couche de LiTaO3 et le substrat support de Si est un des facteurs importants qui gèrent la bonne tenue mécanique de la structure en température, notamment à des températures supérieures ou égales à 250°C.

Se pose donc le problème de renforcer l'énergie de collage de l'hétéro-structure préalablement aux étapes de fabrication du dispositif à ondes acoustiques, dans une gamme de température autour de 250°C, et ce malgré la différence significative de coefficient de dilatation thermique (CTE pour « Coefficient of Thermal Expansion » selon la terminologie anglo-saxonne) des deux matériaux.

Par ailleurs, lorsqu'une hétéro-structure comportant une très fine couche de LiTaO3 est requise (par exemple pour la fabrication de dispositifs à ondes acoustiques de volume ou dispositifs BAW), une solution est de transférer ladite couche par le procédé Smart Cut®, incluant la formation d'un plan fragile enterré dans un substrat donneur de LiTaO3 par introduction d'espèces légères telles que l'hydrogène et/ou l'hélium, le collage direct de ce substrat donneur sur un substrat support en Silicium, et le détachement au niveau du plan fragile enterré de manière à transférer une couche superficielle de LiTaO3 sur Si. Il est connu que la couche superficielle après transfert comprend encore des défauts et des espèces légères dans son épaisseur. Il est donc avantageux, pour guérir cette couche de réaliser un recuit dans une gamme adaptée de température : pour permettre la guérison des défauts et l'évacuation des espèces légères sans endommager les qualités de la couche mince transférée ou la tenue mécanique de l'hétéro-structure. A titre d'exemple, pour une couche de LiTaO3, la gamme de températures adaptée serait choisie entre 400° et 600°C.

Le problème à nouveau est que les hétéro-structures LiTaO3/Si, compte tenu du très grand écart de coefficient de dilatation thermique entre les matériaux LiTaO3 et Si, ne supportent pas ces budgets thermiques élevés.

### OBJET DE L'INVENTION

Un objet de l'invention est donc de proposer une structure et un procédé de fabrication obviant les inconvénients de l'art antérieur. Un objet de l'invention est notamment de proposer une structure composite, comprenant une couche utile disposée sur un support au niveau d'une interface, et capable de supporter des budgets thermiques suffisamment élevés pour renforcer cette interface ou guérir au moins en partie la couche superficielle de ses défauts ou pour élaborer certains composants.

### BREVE DESCRIPTION DE L'INVENTION

L'invention concerne une structure composite pour dispositif à ondes acoustiques comprenant une hétéro-structure incluant :
- une couche utile de matériau piézoélectrique, présentant une première et une seconde face, la première face étant disposée au niveau d'une première interface de collage sur un substrat support présentant un coefficient de dilatation thermique inférieur à celui de la couche utile ;
La structure composite est remarquable en ce qu'elle comprend une couche fonctionnelle dont toute une surface est disposée au niveau d'une seconde interface de collage sur la seconde face de la couche utile et présentant un coefficient de dilatation thermique inférieur à celui de la couche utile.

La structure composite selon l'invention supporte ainsi une température supérieure à une température limite au-delà de laquelle l'hétéro-structure se dégrade ou casse en l'absence de la couche fonctionnelle. La structure composite permet ainsi d'appliquer des traitements thermiques requis pour consolider la première interface de collage de l'hétéro-structure ou pour guérir la couche utile de défauts ; ces traitements thermiques n'auraient pas pu être appliqués directement à l'hétéro-structure du fait de la différence importante de coefficients de dilatation thermique des matériaux de la couche utile et du substrat support.

Selon des caractéristiques avantageuses de l'invention, prises seules ou en combinaison :
- la couche fonctionnelle a une épaisseur supérieure ou égale à 10 µm;
- la couche utile est composée d'un matériau choisi dans le groupe : tantalate de lithium (LiTaO₃), niobate de lithium (LiNbO₃), nitrure d'aluminium (AlN), oxyde de zinc (ZnO) ;
- la couche fonctionnelle est composée d'un matériau choisi dans le groupe : silicium, semi-conducteurs III-V, carbure de silicium, verre, saphir ;
- le substrat support est composé d'un matériau choisi dans le groupe : silicium, semi-conducteurs III-V, carbure de silicium, verre, saphir ;
- la couche fonctionnelle est composée du même matériau que celui du substrat support ;
- l'énergie d'adhésion de la première interface de collage entre la couche utile et le substrat support de l'hétéro-structure est supérieure ou égale à 1500 mJ/m² ;
- l'énergie d'adhésion de la seconde interface de collage entre la couche fonctionnelle et l'hétéro-structure est inférieure à 1000 mJ/m2, pour permettre son démontage ;
- la couche fonctionnelle comporte au moins une première ouverture locale permettant l'accès à au moins une première partie de la seconde face de la couche utile et ladite première partie de la seconde face de la couche utile comprend des éléments métalliques formant un dispositif à ondes acoustiques, en particulier un dispositif SAW ;
- la couche fonctionnelle comporte au moins une première ouverture locale permettant l'accès à au moins une première partie de la seconde face de la couche utile,
- le substrat support comporte au moins une seconde ouverture locale, au moins partiellement en vis-à-vis avec la première ouverture locale et permettant l'accès à au moins une seconde partie de la première face de la couche utile,
- lesdites première et seconde parties respectivement des seconde et première faces de la couche utile comprennent des éléments métalliques formant un dispositif à ondes acoustiques, en particulier un dispositif BAW ;
- la couche fonctionnelle et/ou le substrat support comporte(nt) des contacts métalliques et/ou des dispositifs électroniques connectés électriquement à des éléments métalliques disposés sur la couche utile.

L'invention concerne en outre un procédé de fabrication d'une structure composite pour dispositif à ondes acoustiques incluant une étape de fourniture d'une hétéro-structure comprenant une couche utile de matériau piézoélectrique, présentant une première et une seconde face, la première face étant disposée au niveau d'une première interface de collage sur un substrat support présentant un coefficient de dilatation thermique inférieur à celui de la couche utile ; le procédé est remarquable en ce qu'il comprend :
- Une étape d'assemblage formant une seconde interface de collage entre toute une surface d'une couche fonctionnelle et la seconde face de la couche utile pour former une structure composite, la couche fonctionnelle ayant un coefficient de dilatation thermique inférieur à celui de la couche utile ;
- Une étape de traitement thermique de la structure composite à une température supérieure à une température limite au-delà de laquelle l'hétéro-structure se dégrade ou casse en l'absence de la couche fonctionnelle.

Selon des caractéristiques avantageuses de l'invention, prises seules ou en combinaison :
- l'étape d'assemblage comprend une étape de mise à épaisseur de la couche fonctionnelle, préalablement à l'étape de traitement thermique, pour arriver une épaisseur de la couche fonctionnelle supérieure ou égale à 10 µm ;
- la température de l'étape de traitement thermique est supérieure ou égale à 250°C, en particulier comprise entre 250° et 600°C ;
- le procédé de fabrication comprend une étape de retrait de la couche fonctionnelle après l'étape de traitement thermique, par un démontage au niveau de la seconde interface de collage entre la couche fonctionnelle et la couche utile ;
- le démontage est effectué par application d'une contrainte mécanique au niveau de la seconde interface de collage de la structure composite ;
- le procédé de fabrication comprend une étape de retrait local de la couche fonctionnelle pour permettre l'accès à une première partie de la seconde face de la couche utile, et une étape de réalisation de dispositifs à ondes acoustiques comprenant des éléments métalliques sur ladite première partie ;
- le procédé de fabrication comprend en outre une étape de retrait local du substrat support pour permettre l'accès à une seconde partie de la première face de la couche utile, et une étape de réalisation de dispositifs à ondes acoustiques comprenant des éléments métalliques sur ladite seconde partie ;
- le procédé de fabrication comprend en outre une étape de réalisation de composants sur la couche fonctionnelle et/ou sur le substrat support, et/ou une étape de connexion électrique entre des éléments métalliques disposés sur la couche utile et des contacts métalliques disposés sur la couche fonctionnelle et/ou sur le substrat support.

### BREVE DESCRIPTION DES DESSINS

D'autres caractéristiques et avantages de l'invention ressortiront de la description détaillée de l'invention qui va suivre en référence aux figures annexées sur lesquelles :
- les figures la à 1c présentent une hétéro-structure et une structure composite conforme à l'invention ;
- les figures 2a à 2c présentent une variante de mise en œuvre de la structure composite ;
- la figure 3 présente une autre variante de mise en œuvre de la structure composite ;
- les figures 4a à 4c présentent des étapes du procédé de fabrication selon l'invention de la structure composite.

### DESCRIPTION DETAILLEE DE L'INVENTION

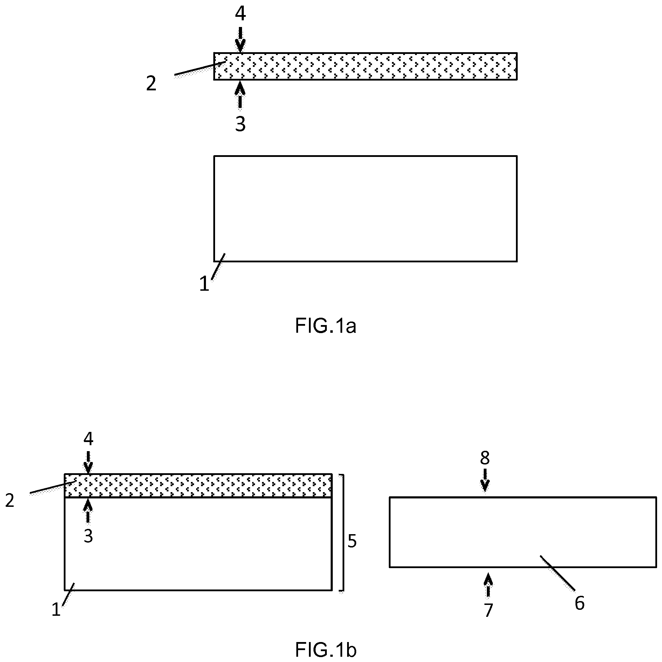

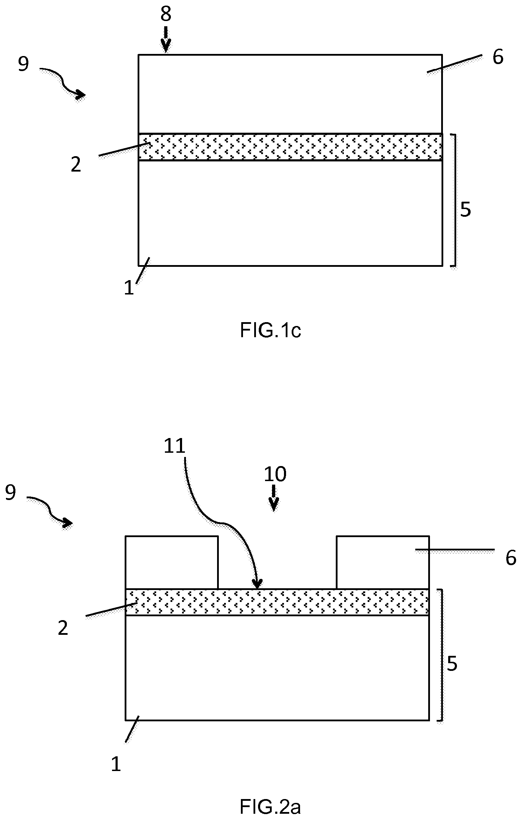

L'invention concerne une structure composite 9 pour dispositif à ondes acoustiques comprenant une hétéro-structure 5 (illustrée sur la figure 1c). Cette dernière inclut une couche utile 2 de matériau piézoélectrique, présentant une première 3 et une seconde face 4, comme illustré sur la figure la. Elle inclut également un substrat support 1 présentant un coefficient de dilatation thermique inférieur à celui de la couche utile 2. Pour former l'hétéro-structure 5, la couche utile 2 est disposée selon sa première face 3 sur le substrat support 1 (figure 1b). La couche utile 2 de l'hétéro-structure 5 pourra être composée d'un matériau choisi dans le groupe : tantalate de lithium (LiTaO₃), niobate de lithium (LiNbO₃), nitrure d'aluminium (AlN), oxyde de zinc (ZnO). Le substrat support 1 de l'hétéro-structure 5 pourra être composé d'un matériau choisi dans le groupe : silicium, semi-conducteurs III-V, carbure de silicium, verre, saphir. L'assemblage de la couche utile 2 sur le substrat support 1 est par exemple réalisé par collage direct par adhésion moléculaire. Selon une variante, une couche supplémentaire (non représentée), par exemple d'oxyde de silicium, pourra être déposée sur le substrat support 1 et/ou sur la première face 3 de la couche utile avant l'assemblage ; cette configuration pourra par exemple faciliter le collage entre la couche utile 2 et le substrat support 1.

Une hétéro-structure 5 comportant une couche utile 2 en matériau piézoélectrique présente un intérêt croissant dans le domaine des dispositifs à ondes acoustiques, notamment utilisés pour les applications de téléphonie mobile et communications radio-fréquences. Pour fabriquer des dispositifs à ondes acoustiques sur une hétéro-structure 5, plusieurs étapes sont nécessaires, parmi lesquelles des dépôts de couches isolantes et conductrices, des gravures humides ou sèches, des traitements thermiques (dans la gamme 150-250°C). La demanderesse a remarqué qu'une bonne consolidation de l'interface de collage entre la couche utile 2 et le substrat support 1 favorisait la tenue de l'hétéro-structure 5 au cours des étapes d'élaboration des dispositifs, notamment les étapes de traitement thermique. La structure composite 9 selon l'invention a donc notamment pour objet de permettre le renforcement de l'énergie de collage de l'interface entre la couche utile 2 et le substrat support 1 (dite première interface de collage) de l'hétéro-structure 5, en vue des étapes subséquentes d'élaboration de dispositifs.

La structure composite 9 selon l'invention comprend ainsi une couche fonctionnelle 6, présentant deux faces 7 et 8 (figure 1b). Cette couche 6 est assemblée sur la seconde face 4 de la couche utile 2, de sorte que toute la surface de l'une de ses faces 7,8 (en l'occurrence la face 7, sur la figure 1c) soit disposée sur la seconde face 4 de la couche utile 2 (au niveau d'une seconde interface de collage). La couche fonctionnelle 6 présente par ailleurs un coefficient de dilatation thermique inférieur à celui de la couche utile 2. La couche fonctionnelle 6 pourra être composée d'un matériau choisi dans le groupe : silicium, semi-conducteurs III-V, carbure de silicium, verre, saphir. Avantageusement, la couche fonctionnelle 6 pourra être composée du même matériau que le substrat support 1. Selon une variante, une couche intermédiaire (non représentée) pourra être présente entre la couche fonctionnelle 6 et la couche utile 2, par exemple en oxyde de silicium, en nitrure de silicium, etc. La couche intermédiaire pourra avoir été déposée, sur la seconde face 4 de la couche utile 2 et/ou sur la face 7 de la couche fonctionnelle 6 avant assemblage.

La structure composite 9 selon l'invention est compatible avec une température de traitement thermique supérieure à une température limite au-delà de laquelle l'hétéro-structure 5 se dégrade ou casse en l'absence de la couche fonctionnelle 6. En effet, du fait de la forte différence de coefficient de dilatation thermique (CTE pour « Coefficient of thermal expansion ») entre le matériau piézoélectrique formant la couche utile 2 et le matériau formant le substrat support 1, l'hétéro-structure 5 va se dégrader (fissuration ou casse du substrat support 1, décollement de la couche utile 2 au niveau de sa première face 3, dislocation ou déformation de la couche utile 2) si elle est soumise à une température supérieure à une température limite ; cette température limite est liée à la différence de CTE entre la couche utile 2 et le substrat support 1 et aux épaisseurs respectives de la couche utile 2 et du substrat support 1. A titre d'exemple, pour une hétéro-structure 5 composée d'une couche utile 2 en LiTaO₃ d'une épaisseur de 10 µm et d'un substrat support 1 en Si d'une épaisseur de 625 µm, la température limite est de l'ordre de 150°C. La structure composite 9 selon l'invention autorise l'application d'une température supérieure à cette température limite. Par exemple, l'ajout d'une couche fonctionnelle 6 en Si d'une épaisseur de 200 µm sur l'exemple d'hétéro-structure 5 précité autorise l'application d'un traitement thermique dans la gamme 200-400°C. Un traitement thermique dans cette gamme de température est avantageux pour la consolidation de la première interface de collage entre la couche utile 2 et le substrat support 1 de l'hétéro-structure 5 et permet d'atteindre des énergies de collage plus élevées qu'un traitement inférieur à 150°C.

Une hétéro-structure 5 comportant une couche utile 2 très fine en matériau piézoélectrique peut également présenter un intérêt dans le domaine des dispositifs à ondes acoustiques, notamment des dispositifs BAW. Une solution pour fabriquer une telle hétéro-structure est de transférer ladite couche utile 2 par le procédé Smart Cut®, incluant la formation d'un plan fragile enterré dans un substrat donneur de matériau piézoélectrique par introduction d'espèces légères telles que l'hydrogène ou l'hélium, le collage direct de ce substrat donneur sur un substrat support 1 en silicium, et le détachement au niveau du plan fragile enterré de manière à transférer une couche superficielle de matériau piézoélectrique sur Si. Il est connu que la couche superficielle après transfert comprend encore des défauts et des espèces légères dans son épaisseur, qui peuvent notamment dégrader ses caractéristiques piézoélectriques. Il est donc important, pour guérir cette couche, d'appliquer un traitement thermique dans une gamme adaptée de température : pour permettre la guérison d'au moins une partie des défauts et l'évacuation des espèces légères, mais sans endommager les qualités de la couche mince transférée ou la tenue mécanique de l'hétéro-structure 5. A titre d'exemple, pour une couche de LiTaO3, la gamme de températures adaptée serait choisie entre 400° et 600°C, soit en-dessous de la température de Curie du matériau.

La structure composite 9 selon l'invention a également pour objet de permettre l'application d'un recuit de guérison à la couche utile 2 de l'hétéro-structure 5, afin de restaurer ses caractéristiques piézoélectriques. A titre d'exemple, pour une hétéro-structure 5 composée d'une couche utile 2 en LiTaO3 d'une épaisseur de 0,5 µm et d'un substrat support 1 en Si d'une épaisseur de 625 µm, la température limite est de l'ordre de 400°C. La structure composite 9 selon l'invention autorise l'application d'une température supérieure à cette température limite. Par exemple, l'ajout d'une couche fonctionnelle 6 en Si d'une épaisseur de 50-100 µm sur l'hétéro-structure 5 précitée autorise l'application d'un traitement thermique dans la gamme 500-600°C.

Avantageusement, et compte tenu des différences importantes de CTE entre la couche utile 2 et le substrat support 1 (et la couche fonctionnelle 6), la couche fonctionnelle 6 aura une épaisseur supérieure ou égale à 10 µm. Préférentiellement, la couche fonctionnelle 6 aura même une épaisseur supérieure ou égale à 50 µm.

Selon une première variante de mise en œuvre de la structure composite 9 conforme à l'invention, la couche fonctionnelle 6 est retirée après l'application, à la structure composite 9, du traitement thermique destiné à consolider la première interface de collage de l'hétéro-structure 5 et/ou à guérir tout ou partie des défauts dans la couche utile 2. L'énergie d'adhésion de la seconde interface de collage entre la couche fonctionnelle 6 et la seconde face 4 de la couche utile 2 de l'hétéro-structure 5 sera choisie inférieure à 1000 mJ/m², pour permettre le démontage de la couche fonctionnelle 6. Le terme démontage est ici utilisé pour traduire la séparation entre la couche fonctionnelle 6 et l'hétéro-structure 5 au niveau de la seconde interface de collage.

La présente invention permet ainsi l'obtention d'une hétéro-structure 5 dont la tenue mécanique (interface de collage consolidée) et les caractéristiques électriques (défauts de la couche utile totalement ou partiellement guéris) sont compatibles avec l'élaboration subséquente des dispositifs à onde acoustiques sur la couche utile 2. En particulier, l'énergie d'adhésion entre la couche utile 2 et le substrat support 1 de l'hétéro-structure 5 est supérieure ou égale à 1500 mJ/m².

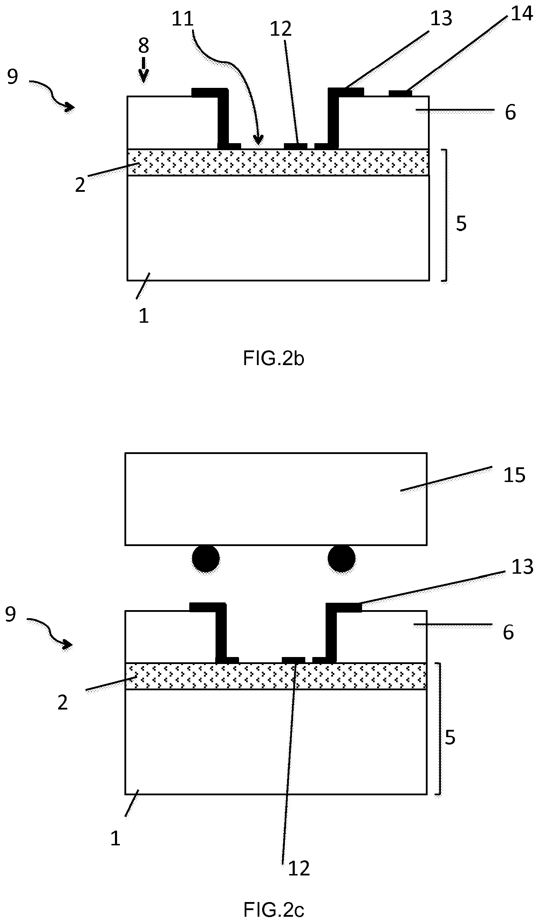

Selon une deuxième variante de mise en œuvre de la structure composite 9 conforme à l'invention, et comme représenté sur la figure 2a, une ou plusieurs première(s) ouverture (s) locale (s) 10 est (sont) aménagée (s) dans la couche fonctionnelle 6 de la structure composite 9, permettant l'accès à au moins une première partie 11 de la seconde face 4 de la couche utile 2. Il est ainsi possible d'élaborer des composants sur la couche utile 2, au niveau de la au moins une première partie 11. La première partie 11 de la seconde face 4 de la couche utile comprend notamment des éléments métalliques 12 formant un dispositif à ondes acoustiques, en particulier un dispositif SAW (figure 2b). Les éléments métalliques 12 pourront par exemple consister en des électrodes interdigitées et des plots de contacts associés.

La structure composite 9 selon cette deuxième variante peut procurer une tenue mécanique plus avantageuse que l'hétéro-structure 5 seule : elle pourra en particulier être compatible avec des traitements thermiques plus élevés par rapport à une hétéro-structure 9 dépourvue de couche fonctionnelle 6, pendant la fabrication du dispositif à ondes acoustiques.

Selon un mode optionnel de cette deuxième variante, la couche fonctionnelle 6 comporte des contacts métalliques 13 et/ou des dispositifs électroniques 14 connectés électriquement à certains éléments métalliques 12 disposés sur la couche utile 2. La structure composite 9 permet dans ce mode de mise en œuvre de déporter les plots de contact des dispositifs SAW présents sur la couche utile 2, sur la face 8 de la couche fonctionnelle 6 ; cette configuration peut être intéressante notamment pour faciliter des interconnexions verticales et un assemblage avec un capot 15 (« wafer level packaging », illustré sur la figure 2c). La structure composite 9 permet en outre de réaliser une co-intégration de composants, certains 12 élaborés sur un matériau piézoélectrique (la couche utile 2), d'autres 14 élaborés sur la couche fonctionnelle 6 (par exemple une couche semiconductrice de type silicium).

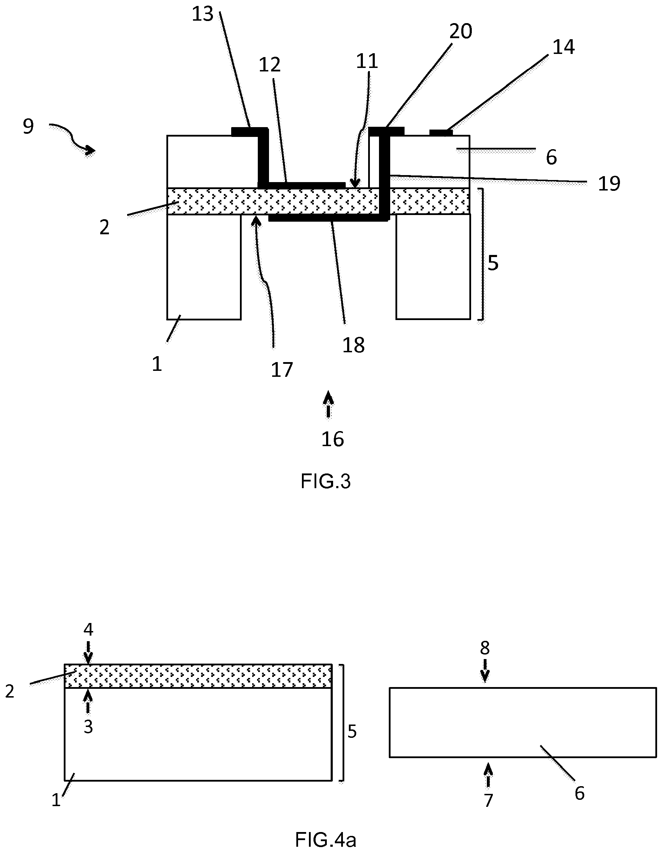

Selon une troisième variante de mise en œuvre de la structure composite 9 conforme à l'invention, et comme représenté sur la figure 3, le substrat support 1 comporte lui-aussi une (ou plusieurs) seconde ouverture locale 16 permettant l'accès à au moins une seconde partie 17 de la première face 3 de la couche utile 2. La seconde ouverture locale 16 sera au moins partiellement en vis-à-vis avec une première ouverture locale 10 aménagée dans la couche fonctionnelle 6 ; la première ouverture locale 10 permet l'accès à au moins une première partie 11 de la seconde face 4 de la couche utile 2. Les première 11 et seconde 17 parties respectivement des seconde 4 et première 3 faces de la couche utile 2 comprennent des éléments métalliques formant un dispositif à ondes acoustiques, par exemple un dispositif BAW. La couche fonctionnelle 6 et/ou le substrat support 1 comporte(nt) des contacts métalliques 13,20 et/ou des dispositifs électroniques 14 connectés électriquement à certains éléments métalliques 12,18 disposés sur les première 11 et seconde 17 parties de la couche utile 2. Comme illustré sur la figure 3, des éléments métalliques 18 disposés sur la seconde partie 17 de la couche utile 2 pourront être connectés à des plots de contact 20 de la couche fonctionnelle 6 à l'aide de vias conductrices traversantes 19.

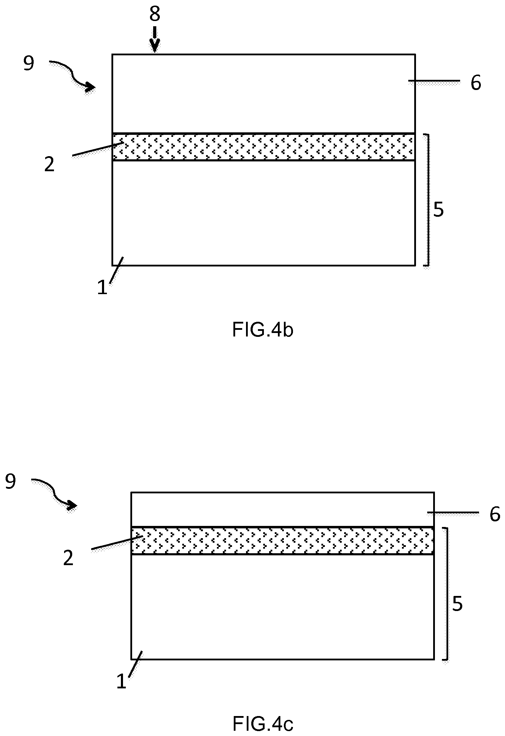

L'invention concerne également un procédé de fabrication d'une structure composite 9 pour dispositif à ondes acoustiques. Le procédé inclut une étape de fourniture d'une hétéro-structure 5 comprenant une couche utile 2 de matériau piézoélectrique, présentant une première face 3 et une seconde face 4 (figure 4a). La première face 3 est disposée sur un substrat support 1 présentant un coefficient de dilatation thermique inférieur à celui de la couche utile 2. Le procédé comprend en outre une étape d'assemblage de toute la surface d'une face 7 d'une couche fonctionnelle 6 (figure 4a) sur la seconde face 4 de la couche utile 2 pour former la structure composite 9 (figure 4b), la couche fonctionnelle 6 ayant un coefficient de dilatation thermique inférieur à celui de la couche utile 2. Cette étape d'assemblage pourra consister en un collage direct par adhésion moléculaire. Les surfaces à assembler respectivement de la couche fonctionnelle 6 et de la couche utile 2 pourront avantageusement subir une séquence de nettoyages permettant de les préparer en vue d'un collage direct. Par exemple, un nettoyage chimique à base d'ozone puis de RCA pourra être appliqué ainsi qu'un traitement plasma O2 ou N2 d'activation de surface. Optionnellement, une couche intermédiaire pourra être déposée sur la face 7 de la couche fonctionnelle 6 et/ou sur la face 4 de la couche utile 2, par exemple une couche d'oxyde de silicium ou de nitrure de silicium.

Le procédé selon l'invention comprend également une étape de traitement thermique de la structure composite 9 à une température supérieure à une température limite au-delà de laquelle l'hétéro-structure 5 se dégrade ou casse en l'absence de la couche fonctionnelle 6. En effet, du fait de la forte différence de coefficient de dilatation thermique (CTE pour « Coefficient of thermal expansion ») entre le matériau piézoélectriques formant la couche utile 2 et le matériau formant le substrat support 1, l'hétéro-structure 5 va se dégrader (fissuration ou casse du substrat support 1, décollement de la couche utile 2 au niveau de sa première face 3, dislocation ou déformation de la couche utile 2) quand on lui applique une température supérieure à une température limite ; cette température limite est liée à la différence de CTE entre couche utile 2 et substrat support 1 et aux natures et épaisseurs respectives de la couche utile 2 et du substrat support 1.

Il est important que toute la surface de la face 7 de la couche fonctionnelle 6 soit assemblée sur la seconde face 4 de la couche utile 2, de manière à contrôler uniformément la dilatation différentielle entre la couche fonctionnelle 6 et la couche utile 2 et à procurer la meilleure tenue mécanique à la structure composite pendant le traitement thermique ultérieur. Un collage local de la couche fonctionnelle 6 sur la couche utile 2 serait moins favorable à la tenue mécanique de la structure composite 9 à des températures supérieures à la température limite que supporte l'hétéro-structure 5. Lors de l'étape de traitement thermique, la structure composite 9 sera ainsi compatible avec une température supérieure ou égale à 250°C, en particulier comprise entre 250° et 600°C, selon les matériaux et les épaisseurs respectifs des couches fonctionnelle 6, utile 2 et du substrat support 1.

Selon une variante, le procédé conforme à l'invention comprend une étape de mise à épaisseur de la couche fonctionnelle 6 (figure 4c), préalablement à l'étape de traitement thermique, pour arriver à une épaisseur de la couche fonctionnelle 6 supérieure ou égale à une épaisseur seuil. Avantageusement cette épaisseur seuil sera choisie supérieure ou égale à 10 µm. Préférentiellement, la couche fonctionnelle 6 aura même une épaisseur supérieure ou égale à 50 µm.

L'étape de mise à épaisseur peut consister en un amincissement mécanique, mécano-chimique et/ou chimique.

Selon une première variante de mise en œuvre, le procédé selon l'invention peut comprendre une étape de retrait de la couche fonctionnelle 6 après l'étape de traitement thermique, par un démontage au niveau d'une interface de collage de la structure composite 9, entre la couche fonctionnelle 6 et la couche utile 2 (dite seconde interface de collage). L'étape d'assemblage du procédé entre la couche fonctionnelle 6 et la couche utile 2 aura été réalisée de sorte que la seconde interface de collage puisse être ultérieurement démontée ; en particulier, elle aura été réalisée de sorte que l'énergie de collage à cette interface soit inférieure à 1000mJ/m². A titre d'exemple, l'étape d'assemblage pourra consister en un collage oxyde/oxyde, la face 7 de la couche fonctionnelle 6 et la face 4 de la couche utile 2 étant munies d'une couche d'oxyde de silicium. La rugosité de surface des couches d'oxyde sera choisie dans la gamme de 0,1 à 0,5nm RMS, de manière à obtenir une énergie de collage inférieure à 1000mJ/m², par exemple de l'ordre de 500mJ/m².

Le démontage, après l'étape de traitement thermique, pourra par exemple être effectué par application d'une contrainte mécanique au niveau de la seconde interface de collage de la structure composite 9, c'est-à-dire au niveau de l'interface entre la couche fonctionnelle 9 et la couche utile 2.

A la suite de cette étape de retrait de la couche fonctionnelle 9, on obtient l'hétéro-structure 5 avec une interface de collage consolidée, compatible avec les étapes subséquentes de fabrication d'un dispositif à ondes acoustiques.

De manière alternative, le retrait total de la couche fonctionnelle 6 peut être réalisé grâce à des techniques d'amincissement mécanique, mécano-chimique ou chimique.

Selon une deuxième variante de mise en œuvre, le procédé selon l'invention comprend une étape de retrait local de la couche fonctionnelle 6 pour permettre l'accès à au moins une première partie 11 de la seconde face 4 de la couche utile 2. Cette étape de retrait local peut consister en une gravure chimique humide ou sèche au niveau de zones définies par exemple par des techniques de photolithographie. A titre d'exemple, on pourra réaliser un retrait local sur une pluralité de zones permettant l'accès à un pourcentage (taux d'ouverture) de la seconde face 4 de la couche utile 2 ; le taux d'ouverture pourra être compris entre quelques % et <100%, en fonction des dispositifs à élaborer. Le procédé comprend ensuite une étape de réalisation de dispositifs à ondes acoustiques comprenant des éléments métalliques 12 sur la pluralité de premières parties 11 (figure 2b). Cette étape de réalisation de dispositifs pourra notamment comprendre l'élaboration de plots de contact 13 sur la couche fonctionnelle 6, connectés électriquement avec les dispositifs à ondes acoustiques présents sur la couche utile 2.

Selon une troisième variante de mise en œuvre, qui peut être ou non combiné avec le deuxième mode de mise en œuvre, le procédé selon l'invention, peut en outre comprendre une étape de retrait local du substrat support 1 pour permettre l'accès à au moins une seconde partie 17 de la première face 3 de la couche utile 2. Cette étape de retrait local peut consister en une gravure chimique humide ou sèche au niveau de zones définies par exemple par des techniques de photolithographie. A titre d'exemple, on pourra réaliser un retrait local sur une pluralité de zones avec un taux d'ouverture compris entre 1 et 50%. Avantageusement, pour permettre la réalisation de dispositifs à ondes acoustiques de volume, la pluralité de secondes parties 17 et la pluralités de premières parties 11 seront au moins partiellement en vis-à-vis, permettant ainsi l'obtention d'une membrane locale auto-portée de couche utile 2. Le procédé comprend ensuite une étape de réalisation de dispositifs à ondes acoustiques comprenant des éléments métalliques 18 sur la pluralité de secondes parties 17 de la couche utile 2, comme illustré sur la figure 3.

Optionnellement, le procédé pourra comprendre une étape de réalisation de composants 14 sur la couche fonctionnelle 6 et/ou sur le substrat support 1, et/ou une étape connexion électrique entre des éléments métalliques 12,18 disposés sur la couche utile 2 et des contacts métalliques 13,20 disposés sur la couche fonctionnelle 6 et/ou sur le substrat support 1.

### Exemple 1 :

Une hétéro-structure 5 comportant une couche utile 2 en niobate de lithium (LiNbO3) d'une épaisseur de 20 µm et un substrat support 1 en silicium (Si) d'une épaisseur de 625 µm et de 150mm de diamètre présente une énergie de collage très inférieure à 1J/m². Avant la réalisation des dispositifs à ondes acoustiques sur cette hétéro-structure, il est indispensable de renforcer son interface de collage ; pour cela, il est nécessaire de lui appliquer un traitement thermique à une température de 250°C, pendant 2h.

La couche fonctionnelle 6 est un substrat de silicium (de diamètre 150mm et d'épaisseur 625 µm) comportant une couche intermédiaire d'oxyde de silicium de 400nm d'épaisseur sur sa face avant 7. La couche d'oxyde de silicium a une rugosité de surface de l'ordre de 0,2nm RMS. La couche fonctionnelle 6 subit ensuite un nettoyage (typiquement ozone et RCA), préalablement à son assemblage sur la seconde face 4 de la couche utile 2 de l'hétéro-structure 5. On applique ensuite le traitement thermique à 250°C pendant 2h à la structure composite 9. Celle-ci est capable de supporter un budget thermique de 250°C / 2h, sans être endommagée et sans générer de dégradation de l'hétéro-structure 5. L'hétéro-structure 5, seule, aurait subi une dégradation (fissuration ou casse du substrat support 1 et/ou décollement partiel ou total de la couche utile 2), si elle avait été soumise avant renforcement de son interface de collage à ce budget thermique, voire même à une budget thermique inférieur de l'ordre de 200°C.

Le traitement thermique réalisé, la couche fonctionnelle 6 est démontée par insertion d'un outil en forme de biseau au niveau de l'interface de collage entre la couche fonctionnelle 6 et la couche utile 2. L'hétéro-structure 5 présente une interface de collage renforcée, de l'ordre de 1,5J/m² qui lui assure une bonne tenue mécanique lors des étapes subséquentes d'élaboration des dispositifs à ondes acoustiques.

### Exemple 2 :

Une hétéro-structure 9 est formée à partir d'une couche utile 2 en tantalate de lithium (LiTaO3) d'une épaisseur de 0,3 µm et d'un substrat support 1 en silicium (Si) d'une épaisseur de 625 µm et de 150mm de diamètre. La couche utile 2 a été reportée par le procédé Smart Cut® et présente après détachement des défauts dans son épaisseur prohibitifs pour la réalisation de dispositifs à ondes acoustiques, car impactant les propriétés piézoélectriques de la couche utile 2. Avant la réalisation des dispositifs à ondes acoustiques sur cette hétéro-structure 5, il est donc indispensable de guérir tout ou partie de ces défauts ; pour cela, il est nécessaire de lui appliquer un traitement thermique à une température de 550°C, pendant 2h.

La couche fonctionnelle 6 est un substrat de silicium (de diamètre 150mm et d'épaisseur 625 µm) comportant une couche intermédiaire d'oxyde de silicium de 400nm d'épaisseur sur sa face avant 7 ; elle subit un nettoyage (typiquement ozone et RCA) et un traitement plasma O2, préalablement à son assemblage sur la seconde face 4 de la couche utile 2 de l'hétéro-structure 5. Une étape de mise à épaisseur de la couche fonctionnelle 6 est ensuite opérée par amincissement mécanique (grinding), puis par polissage mécano-chimique, jusqu'à une épaisseur finale de 200 µm.

La structure composite 9 ainsi formée est capable de supporter un budget thermique de 550°C / 2h, sans être endommagée et sans générer de dégradation de l'hétéro-structure 5. L'hétéro-structure 5, seule, aurait subi une dégradation (fissuration ou casse du substrat support 1 et/ou décollement partiel ou total de la couche utile 2), si elle avait été soumise à ce budget thermique sans la couche fonctionnelle 6.

Le traitement thermique ayant été appliqué à la structure composite 9, la couche fonctionnelle 6 est démontée par apport d'une contrainte localisée au niveau de la seconde interface de collage entre la couche fonctionnelle 6 et la couche utile 2. Alternativement, la couche fonctionnelle 6 est retirée par une séquence d'amincissement mécanique puis chimique.

L'hétéro-structure 5 présente une interface de collage renforcée, supérieure ou égale à 1,5J/m² du fait du budget thermique appliqué et la couche utile 2 a été guérie de la majorité des défauts liés à l'implantation d'espèces légères hydrogène ou hélium (procédé Smart Cut®), devenant compatible avec la réalisation de dispositifs à ondes acoustiques. A titre d'exemple, le niveau de guérison des défauts dans la couche utile 2 peut être évalué par la réalisation de dispositifs électriques et le test de leur niveau de performance, permettant de valider la qualité électrique de ladite couche utile 2.

### Exemple 3 :

Une hétéro-structure 9 est formée à partir d'une couche utile 2 en tantalate de lithium (LiTaO3) d'une épaisseur de 0,3 µm et d'un substrat support 1 en silicium (Si) d'une épaisseur de 625 µm et de 150mm de diamètre. La couche utile 2 a été reportée par le procédé Smart Cut® et présente après détachement des défauts dans son épaisseur prohibitifs pour la réalisation de dispositifs à ondes acoustiques, car impactant les propriétés piézoélectriques de la couche utile 2. Avant la réalisation des dispositifs à ondes acoustiques sur cette hétéro-structure 5, il est donc indispensable de guérir ces défauts ; pour cela, il est nécessaire de lui appliquer un traitement thermique à une température de 500°C, pendant 2h.

La couche fonctionnelle 6 est un substrat de silicium (de diamètre 150mm et d'épaisseur 625 µm) comportant une couche intermédiaire d'oxyde de silicium de 400nm d'épaisseur sur sa face avant 7 ; elle subit un nettoyage (typiquement ozone et RCA) et un traitement plasma O2, préalablement à son assemblage sur la seconde face 4 de la couche utile 2 de l'hétéro-structure 9. Une étape de mise à épaisseur de la couche fonctionnelle 6 est ensuite opérée par amincissement mécanique (grinding), puis par polissage mécano-chimique, jusqu'à une épaisseur finale de 10 µm.

La structure composite 9 ainsi formée est capable de supporter un budget thermique de 500°C / 2h, sans être endommagée et sans générer de dégradation de l'hétéro-structure 5. L'hétéro-structure 5, seule, aurait subi une dégradation (fissuration ou casse du substrat support 1 et/ou décollement partiel ou total de la couche utile 2), si elle avait été soumise à ce budget thermique sans la couche fonctionnelle 6.

Le traitement thermique ayant été appliqué à la structure composite 9, l'hétéro-structure 5 présente une interface de collage renforcée, supérieure à 1,5J/m² du fait du budget thermique appliqué et la couche utile 2 a été guérie d'une grande partie des défauts liés à l'implantation d'espèces légères hydrogène ou hélium (procédé Smart Cut®), devenant compatible avec la réalisation de dispositifs à ondes acoustiques.

On réalise ensuite une étape de retrait local de la couche fonctionnelle 6 pour permettre l'accès à au moins une première partie 11 de la seconde face 4 de la couche utile 2. Cette étape de retrait local peut consister en une gravure chimique humide ou sèche au niveau de zones définies par photolithographie. Le retrait local peut être effectué sur une pluralité de zones permettant l'accès à une pluralité de premières parties 11, et représentant un taux d'ouverture de l'ordre de 50%. Des dispositifs à ondes acoustiques peuvent ensuite être élaborés sur la pluralité de premières parties 11 de la couche utile 2. Ces dispositifs comprennent des éléments métalliques 12, typiquement des électrodes interdigitées. La présence même partielle de la couche fonctionnelle 6 sur la couche utile 2 autorise la réalisation de traitements à plus hautes températures que dans le cas où l'hétéro-structure 5 serait seule ; cela est favorable à l'utilisation de matériaux ou de technologies plus performants pour la réalisation des dispositifs à ondes acoustiques.

Des plots de contact 13 sur la couche fonctionnelle 6 peuvent être connectés électriquement avec les dispositifs à ondes acoustiques présents sur la couche utile 2. Des composants peuvent également être élaborés sur la couche fonctionnelle 6. La structure composite 9 facilite ainsi la co-intégration de composants élaborés sur matériau piézoélectrique (la couche utile) et sur matériau semiconducteur (la couche fonctionnelle).

Bien entendu, l'invention n'est pas limitée aux seuls modes de mise en œuvre décrits et on peut y apporter des variantes de réalisation sans sortir du cadre de l'invention tel que défini par les revendications.

La structure composite selon l'invention présente un grand intérêt pour la fabrication de dispositifs à ondes acoustiques, par exemple dans le domaine des filtres SAW et BAW pour les applications radio-fréquences, mais également dans le domaine des capteurs piézoélectriques. En effet, ces derniers permettant la transformation de mouvements mécaniques en signal électrique, et ce avec une très grande sensibilité, plusieurs champs d'application s'ouvrent ou sont susceptibles de s'ouvrir dans les domaines des capteurs de température, de l'énergie (« energy harvesting »), etc.

## Revendications

1. Structure composite (9) pour dispositif à ondes acoustiques comprenant une hétéro-structure (5) incluant :
une couche utile (2) de matériau piézoélectrique, présentant une première (3) et une seconde (4) face, la première face (3) étant disposée au niveau d'une première interface de collage sur un substrat support (1) présentant un coefficient de dilatation thermique inférieur à celui de la couche utile (2),
la structure composite (9) étant **caractérisée en ce qu'**elle comprend une couche fonctionnelle (6) dont toute une surface est disposée au niveau d'une seconde interface de collage sur la seconde face (4) de la couche utile (2) et présentant un coefficient de dilatation thermique inférieur à celui de la couche utile (2).

2. Structure composite (9) pour dispositif à ondes acoustiques selon la revendication précédente, dans laquelle la couche fonctionnelle (6) a une épaisseur supérieure ou égale à 10 µm.

3. Structure composite (9) pour dispositif à ondes acoustiques selon l'une des revendications précédentes, dans laquelle la couche utile (2) est composée d'un matériau choisi dans le groupe : tantalate de lithium (LiTaO₃), niobate de lithium (LiNbO₃), nitrure d'aluminium (AlN), oxyde de zinc (ZnO).

4. Structure composite (9) pour dispositif à ondes acoustiques selon l'une des revendications précédentes, dans laquelle la couche fonctionnelle (6) est composée d'un matériau choisi dans le groupe : silicium, semi-conducteurs III-V, carbure de silicium, verre, saphir.

5. Structure composite (9) pour dispositif à ondes acoustiques selon l'une des revendications précédentes, dans laquelle le substrat support (1) est composé d'un matériau choisi dans le groupe : silicium, semi-conducteurs III-V, carbure de silicium, verre, saphir.

6. Structure composite (9) pour dispositif à ondes acoustiques selon l'une des revendications précédentes, dans laquelle la couche fonctionnelle (6) est composée du même matériau que celui du substrat support (1).

7. Structure composite (9) pour dispositif à ondes acoustiques selon l'une des revendications précédentes, dans laquelle l'énergie d'adhésion de la première interface de collage entre la couche utile (2) et le substrat support (1) de l'hétéro-structure (5) est supérieure ou égale à 1500 mJ/m².

8. Structure composite (9) pour dispositif à ondes acoustiques selon l'une des revendications précédentes, dans laquelle l'énergie d'adhésion de la seconde interface de collage entre la couche fonctionnelle (6) et l'hétéro-structure (5) est inférieure à 1000 mJ/m², pour permettre son démontage.

9. Structure composite (9) pour dispositif à ondes acoustiques selon l'une des revendications 1 à 7, dans laquelle la couche fonctionnelle (6) comporte au moins une première ouverture locale (10) permettant l'accès à au moins une première partie (11) de la seconde face (4) de la couche utile (2) et dans laquelle ladite première partie (11) de la seconde face (4) de la couche utile (2) comprend des éléments métalliques (12) formant un dispositif à ondes acoustiques, en particulier un dispositif SAW.

10. Structure composite (9) pour dispositif à ondes acoustiques selon l'une des revendications 1 à 7, dans laquelle :
• la couche fonctionnelle (2) comporte au moins une première ouverture locale (10) permettant l'accès à au moins une première partie (11) de la seconde face (4) de la couche utile (2),
• le substrat support (1) comporte au moins une seconde ouverture locale (16), au moins partiellement en vis-à-vis avec la première ouverture locale (10) et permettant l'accès à au moins une seconde partie (17) de la première face (3) de la couche utile (2),
• lesdites première (11) et seconde (17) parties respectivement des seconde (4) et première (3) faces de la couche utile (2) comprennent des éléments métalliques (12,18) formant un dispositif à ondes acoustiques, en particulier un dispositif BAW.

11. Structure composite (9) pour dispositif à ondes acoustiques selon l'une des deux revendications précédentes, dans laquelle la couche fonctionnelle (6) et/ou le substrat support (1) comporte(nt) des contacts métalliques (13) et/ou des dispositifs électroniques (14) connectés électriquement à des éléments métalliques (12,18) disposés sur la couche utile.

12. Procédé de fabrication d'une structure composite (9) pour dispositif à ondes acoustiques incluant une étape de fourniture d'une hétéro-structure (5) comprenant une couche utile (2) de matériau piézoélectrique, présentant une première (3) et une seconde (4) face, la première face (3) étant disposée au niveau d'une première interface de collage sur un substrat support (1) présentant un coefficient de dilatation thermique inférieur à celui de la couche utile (2), le procédé étant **caractérisé en ce qu'**il comprend :
• Une étape d'assemblage formant une seconde interface de collage entre toute une surface d'une couche fonctionnelle (6) et la seconde face (4) de la couche utile (2) pour former une structure composite (9), la couche fonctionnelle (6) ayant un coefficient de dilatation thermique inférieur à celui de la couche utile (2) ;
• Une étape de traitement thermique de la structure composite (9) à une température supérieure à une température limite au-delà de laquelle l'hétéro-structure (5) se dégrade ou casse en l'absence de la couche fonctionnelle (6).

13. Procédé de fabrication d'une structure composite (9) pour dispositif à ondes acoustiques selon la revendication précédente, dans lequel l'étape d'assemblage comprend une étape de mise à épaisseur de la couche fonctionnelle (6), préalablement à l'étape de traitement thermique, pour arriver une épaisseur de la couche fonctionnelle (6) supérieure ou égale à 10 µm.

14. Procédé de fabrication d'une structure composite (9) pour dispositif à ondes acoustiques selon la revendication précédente, dans lequel la température de l'étape de traitement thermique est supérieure ou égale à 250°C, en particulier comprise entre 250° et 600°C.

15. Procédé de fabrication d'une structure composite (9) pour dispositif à ondes acoustiques selon l'une des trois revendications précédentes, comprenant une étape de retrait de la couche fonctionnelle (6) après l'étape de traitement thermique, par un démontage au niveau de la seconde interface de collage entre la couche fonctionnelle (9) et la couche utile (2).

16. Procédé de fabrication d'une structure composite (9) pour dispositif à ondes acoustiques selon la revendication précédente, dans lequel le démontage est effectué par application d'une contrainte mécanique au niveau de la seconde interface de collage de la structure composite (9).

17. Procédé de fabrication d'une structure composite (9) pour dispositif à ondes acoustiques selon l'une des revendications 12 à 14, comprenant une étape de retrait local de la couche fonctionnelle (9) pour permettre l'accès à une première partie (11) de la seconde face (4) de la couche utile (2), et une étape de réalisation de dispositifs à ondes acoustiques comprenant des éléments métalliques (12) sur ladite première partie (11).

18. Procédé de fabrication d'une structure composite (9) pour dispositif à ondes acoustiques selon la revendication précédente, comprenant en outre une étape de retrait local du substrat support (1) pour permettre l'accès à une seconde partie (17) de la première face (3) de la couche utile (2), et une étape de réalisation de dispositifs à ondes acoustiques comprenant des éléments métalliques (18) sur ladite seconde partie (17).

19. Procédé de fabrication d'une structure composite (9) pour dispositif à ondes acoustiques selon l'une des deux revendications précédentes, comprenant en outre une étape de réalisation de composants (14) sur la couche fonctionnelle (6) et/ou sur le substrat support (1), et/ou une étape de connexion électrique entre des éléments métalliques (12,18) disposés sur la couche utile (2) et des contacts métalliques (13,20) disposés sur la couche fonctionnelle (6) et/ou sur le substrat support (1).

## Patentansprüche

1. Verbundstruktur (9) für eine Schallwellenvorrichtung, umfassend eine Heterostruktur (5), aufweisend:
eine Nutzschicht (2) aus piezoelektrischem Material mit einer ersten (3) und einer zweiten (4) Seite, wobei die erste Seite (3) auf einer ersten Verbindungsgrenzfläche auf einem Trägersubstrat (1) mit einem Wärmeausdehnungskoeffizienten angeordnet ist, der niedriger als der der Nutzschicht (2) ist, wobei die Verbundstruktur (9) **dadurch gekennzeichnet ist, dass** sie eine Funktionsschicht (6) umfasst, deren gesamte Oberfläche auf einer zweiten Verbindungsgrenzfläche auf der zweiten Seite (4) der Nutzschicht (2) angeordnet ist, und die einen Wärmeausdehnungskoeffizienten aufweist, der niedriger als der der Nutzschicht (2) ist.

2. Verbundstruktur (9) für eine Schallwellenvorrichtung nach dem vorhergehenden Anspruch, wobei die Funktionsschicht (6) eine Dicke größer oder gleich 10 µm aufweist.

3. Verbundstruktur (9) für eine Schallwellenvorrichtung nach einem der vorhergehenden Ansprüche, wobei die Nutzschicht (2) aus einem Material besteht, ausgewählt aus der Gruppe, bestehend aus:
Lithiumtantalat (LiTaO₃), Lithiumniobat (LiNbO₃), Aluminiumnitrid (AIN), Zinkoxid (ZnO).

4. Verbundstruktur (9) für eine Schallwellenvorrichtung nach einem der vorhergehenden Ansprüche, wobei die Funktionsschicht (6) aus einem Material besteht, ausgewählt aus der Gruppe, bestehend aus: Silicium, III-V-Halbleiter, Siliciumcarbid, Glas, Saphir.

5. Verbundstruktur (9) für eine Schallwellenvorrichtung nach einem der vorhergehenden Ansprüche, wobei das Trägersubstrat (1) aus einem Material besteht, ausgewählt aus der Gruppe, bestehend aus: Silicium, III-V-Halbleiter, Siliciumcarbid, Glas, Saphir.

6. Verbundstruktur (9) für eine Schallwellenvorrichtung nach einem der vorhergehenden Ansprüche, wobei die Funktionsschicht (6) aus dem gleichen Material besteht wie das des Trägersubstrats (1).

7. Verbundstruktur (9) für eine Schallwellenvorrichtung nach einem der vorhergehenden Ansprüche, wobei die Adhäsionsenergie der ersten Verbindungsgrenzfläche zwischen der Nutzschicht (2) und dem Trägersubstrat (1) der Heterostruktur (5) größer oder gleich 1500 mJ/m² ist.

8. Verbundstruktur (9) für eine Schallwellenvorrichtung nach einem der vorhergehenden Ansprüche, wobei die Adhäsionsenergie der zweiten Verbindungsgrenzfläche zwischen der Funktionsschicht (6) und der Heterostruktur (5) kleiner 1000 mJ/m² ist, um deren Zerlegung zu ermöglichen.

9. Verbundstruktur (9) für eine Schallwellenvorrichtung nach einem der Ansprüche 1 bis 7, wobei die Funktionsschicht (6) mindestens eine erste lokale Öffnung (10) aufweist, die den Zugang zu mindestens einem ersten Teil (11) der zweiten Seite (4) der Nutzschicht (2) ermöglicht, und wobei der erste Teil (11) der zweiten Seite (4) der Nutzschicht (2) metallische Elemente (12) umfasst, die eine Schallwellenvorrichtung bilden, insbesondere eine SAW-Vorrichtung.

10. Verbundstruktur (9) für eine Schallwellenvorrichtung nach einem der Ansprüche 1 bis 7, wobei:
• die Funktionsschicht (2) mindestens eine erste lokale Öffnung (10) umfasst, die den Zugang zu mindestens einem ersten Teil (11) der zweiten Seite (4) der Nutzschicht (2) ermöglicht,
• das Trägersubstrat (1) mindestens eine zweite lokale Öffnung (16) umfasst, die zumindest teilweise der ersten lokalen Öffnung (10) gegenüber liegt und den Zugang zu mindestens einem zweiten Teil (17) der ersten Seite (3) der Nutzschicht (2) ermöglicht,
• der erste (11) und der zweite (17) Teil der zweiten (4) bzw. ersten (3) Seite der Nutzschicht (2) metallische Elemente (12, 18) umfassen, die eine Schallwellenvorrichtung, insbesondere eine BAW-Vorrichtung bilden.

11. Verbundstruktur (9) für eine Schallwellenvorrichtung nach einem der beiden vorhergehenden Ansprüche, wobei die Funktionsschicht (6) und/oder das Trägersubstrat (1) Metallkontakte (13) und/oder elektronische Vorrichtungen (14) umfasst/umfassen, das/die elektrisch mit metallischen Elementen (12, 18) verbunden ist/sind, die auf der Nutzschicht angeordnet sind.

12. Verfahren zum Herstellen einer Verbundstruktur (9) für eine Schallwellenvorrichtung, aufweisend einen Schritt zum Bereitstellen einer Heterostruktur (5), umfasst eine Nutzschicht (2) aus piezoelektrischem Material mit einer ersten (3) und einer zweiten (4) Seite, wobei die erste Seite (3) auf einer ersten Verbindungsgrenzfläche auf einem Trägersubstrat (1) mit einem Wärmeausdehnungskoeffizienten angeordnet ist, der kleiner als der der Nutzschicht (2) ist, wobei das Verfahren **dadurch gekennzeichnet ist, dass** es umfasst:
• einen Montageschritt, der eine zweite Verbindungsgrenzfläche zwischen der gesamten Oberfläche einer Funktionsschicht (6) und der zweiten Seite (4) der Nutzschicht (2) bildet, um eine Verbundstruktur (9) zu bilden, wobei die Funktionsschicht (6) einen kleineren Wärmeausdehnungskoeffizient als den der Nutzschicht (2) aufweist;
• einen Wärmebehandlungsschritt der Verbundstruktur (9) bei einer Temperatur oberhalb einer Grenztemperatur, ab der sich die Heterostruktur (5) in Abwesenheit der Funktionsschicht (6) zersetzt oder bricht.

13. Verfahren zum Herstellen einer Verbundstruktur (9) für eine Schallwellenvorrichtung nach dem vorhergehenden Anspruch, wobei der Montageschritt einen Schritt umfasst, um der Funktionsschicht (6) vor dem Wärmebehandlungsschritt eine Dicke zu verleihen, um eine Dicke der Funktionsschicht (6) größer oder gleich 10 µm zu erreichen.

14. Verfahren zum Herstellen einer Verbundstruktur (9) für eine Schallwellenvorrichtung nach dem vorhergehenden Anspruch, wobei die Temperatur des Wärmebehandlungsschritts größer oder gleich 250 °C ist, insbesondere zwischen 250 °C und 600 °C.

15. Verfahren zum Herstellen einer Verbundstruktur (9) für eine Schallwellenvorrichtung nach einem der drei vorhergehenden Ansprüche, umfassend einen Schritt des Entfernens der Funktionsschicht (6) nach dem Wärmebehandlungsschritt durch Zerlegen auf der Ebene der zweiten Verbindungsgrenzfläche zwischen der Funktionsschicht (9) und der Nutzschicht (2).

16. Verfahren zum Herstellen einer Verbundstruktur (9) für eine Schallwellenvorrichtung nach dem vorhergehenden Anspruch, wobei das Zerlegen durch Anwenden einer mechanischen Spannung auf der Ebene der zweiten Verbindungsgrenzfläche der Verbundstruktur (9) erfolgt.

17. Verfahren zum Herstellen einer Verbundstruktur (9) für eine Schallwellenvorrichtung nach einem der Ansprüche 12 bis 14, umfassend einen Schritt des lokalen Entfernens der Funktionsschicht (9), um den Zugang zu einem ersten Teil (11) der zweiten Seite (4) der Nutzschicht (2) zu ermöglichen, und einen Schritt zum Aufbauen von metallische Elemente (12) umfassenden Schallwellenvorrichtungen auf dem ersten Teil (11).

18. Verfahren zum Herstellen einer Verbundstruktur (9) für eine Schallwellenvorrichtung nach dem vorhergehenden Anspruch, fernerumfassend einen Schritt des lokalen Entfernens des Trägersubstrats (1), um den Zugang zu einem zweiten Teil (17) der ersten Seite (3) der Nutzschicht (2) zu ermöglichen, und einen Schritt zum Aufbauen von metallische Elemente (18) umfassenden Schallwellenvorrichtungen auf dem zweiten Teil (17).

19. Verfahren zum Herstellen einer Verbundstruktur (9) für eine Schallwellenvorrichtung nach einem der beiden vorhergehenden Ansprüche, ferner umfassend einen Schritt zum Anfertigung von Bauteilen (14) auf der Funktionsschicht (6) und/oder auf dem Trägersubstrat (1) und/oder einen Schritt des elektrischen Verbindens zwischen metallischen Elementen (12, 18), die auf der Nutzschicht (2) angeordnet sind, und metallischen Kontakten (13, 20), die auf der Funktionsschicht (6) und/oder auf dem Trägersubstrat (1) angeordnet sind.

## Claims

1. Composite structure (9) for an acoustic wave device comprising a heterostructure (5) which includes:
a useful layer (2) of piezoelectric material, having a first face (3) and a second face (4), the first face (3) being arranged at a first bonding interface on a support substrate (1) having a coefficient of thermal expansion lower than that of the useful layer (2),
the composite structure (9) being **characterized in that** it comprises a functional layer (6), an entire surface of which is arranged at a second bonding interface on the second face (4) of the useful layer (2) and which has a coefficient of thermal expansion lower than that of the useful layer (2).

2. Composite structure (9) for an acoustic wave device according to the preceding claim, wherein the functional layer (6) has a thickness greater than or equal to 10 µm.

3. Composite structure (9) for an acoustic wave device according to either of the preceding claims, wherein the useful layer (2) is made of a material selected from the group of: lithium tantalate (LiTaO₃), lithium niobate (LiNbO₃), aluminum nitride (AIN), and zinc oxide (ZnO).

4. Composite structure (9) for an acoustic wave device according to any of the preceding claims, wherein the functional layer (6) is made of a material selected from the group of: silicon, III-V semiconductors, silicon carbide, glass, and sapphire.

5. Composite structure (9) for an acoustic wave device according to any of the preceding claims, wherein the support substrate (1) is made of a material selected from the group of: silicon, III-V semiconductors, silicon carbide, glass, and sapphire.

6. Composite structure (9) for an acoustic wave device according to any of the preceding claims, wherein the functional layer (6) is made of the same material as that of the support substrate (1).

7. Composite structure (9) for an acoustic wave device according to any of the preceding claims, wherein the adhesion energy of the first bonding interface between the useful layer (2) and the support substrate (1) of the heterostructure (5) is greater than or equal to 1500 mJ/m².

8. Composite structure (9) for an acoustic wave device according to any of the preceding claims, wherein the adhesion energy of the second bonding interface between the functional layer (6) and the heterostructure (5) is lower than 1000 mJ/m², to allow said interface to be detached.

9. Composite structure (9) for an acoustic wave device according to any of claims 1 to 7, wherein the functional layer (6) comprises at least a first local opening (10) for accessing at least a first part (11) of the second face (4) of the useful layer (2), and wherein said first part (11) of the second face (4) of the useful layer (2) comprises metal elements (12) forming an acoustic wave device, in particular a SAW device.

10. Composite structure (9) for an acoustic wave device according to any of claims 1 to 7, wherein:
• the functional layer (2) comprises at least a first local opening (10) for accessing at least a first part (11) of the second face (4) of the useful layer (2),
• the support substrate (1) comprises at least a second local opening (16), at least partially facing the first local opening (10) and for accessing at least a second part (17) of the first face (3) of the useful layer (2),
• said first part (11) and said second part (17) of the second face (4) and the first face (3), respectively, of the useful layer (2) comprise metal elements (12, 18) forming an acoustic wave device, in particular a BAW device.

11. Composite structure (9) for an acoustic wave device according to either of the two preceding claims, wherein the functional layer (6) and/or the support substrate (1) comprise(s) metal contacts (13) and/or electronic devices (14) electrically connected to metal elements (12, 18) arranged on the useful layer.

12. Method for manufacturing a composite structure (9) for an acoustic wave device, including a step of providing a heterostructure (5) comprising a useful layer (2) of piezoelectric material, having a first face (3) and a second face (4), the first face (3) being arranged at a first bonding interface on a support substrate (1) having a coefficient of thermal expansion lower than that of the useful layer (2), the method being **characterized in that** it comprises:
• an assembly step forming a second bonding interface between an entire surface of a functional layer (6) and the second face (4) of the useful layer (2) to form a composite structure (9), the functional layer (6) having a coefficient of thermal expansion lower than that of the useful layer (2);
• a step of heat treatment of the composite structure (9) at a temperature greater than a limit temperature above which the heterostructure (5) degrades or breaks in the absence of the functional layer (6).

13. Method for manufacturing a composite structure (9) for an acoustic wave device according to the preceding claim, wherein the assembly step comprises a step of adjusting the thickness of the functional layer (6), prior to the heat treatment step, to achieve a thickness of the functional layer (6) greater than or equal to 10 µm.

14. Method for manufacturing a composite structure (9) for an acoustic wave device according to the preceding claim, wherein the temperature of the heat treatment step is greater than or equal to 250 °C, in particular is between 250 °C and 600 °C.

15. Method for manufacturing a composite structure (9) for an acoustic wave device according to any of the three preceding claims, comprising a step of removing the functional layer (6) after the heat treatment step, by detachment at the second bonding interface between the functional layer (9) and the useful layer (2).

16. Method for manufacturing a composite structure (9) for an acoustic wave device according to the preceding claim, wherein the detachment is carried out by applying mechanical stress at the second bonding interface of the composite structure (9).

17. Method for manufacturing a composite structure (9) for an acoustic wave device according to any of claims 12 to 14, comprising a step of locally removing the functional layer (9) to allow access to a first part (11) of the second face (4) of the useful layer (2), and a step of producing acoustic wave devices comprising metal elements (12) on said first part (11).

18. Method for manufacturing a composite structure (9) for an acoustic wave device according to the preceding claim, further comprising a step of locally removing the support substrate (1) to allow access to a second part (17) of the first face (3) of the useful layer (2), and a step of producing acoustic wave devices comprising metal elements (18) on said second part (17).

19. Method for manufacturing a composite structure (9) for an acoustic wave device according to either of the two preceding claims, further comprising a step of producing components (14) on the functional layer (6) and/or on the substrate support (1), and/or a step of establishing electrical connection between metal elements (12, 18) arranged on the useful layer (2) and metal contacts (13, 20) arranged on the functional layer (6) and/or on the support substrate (1).
